# EUROPEAN PATENT APPLICATION

(11) **EP 4 520 716 A1**
(43) Date of publication of application: **12.03.2025**
(21) Application number: 24195132.6
(22) Date of filing: 19.08.2024
(51) Int. Cl.: B81B 3/00

(54) **PROCESS FOR MANUFACTURING MICROELECTROMECHANICAL DEVICES WITH REDUCED STICTION PHENOMENON**

(30) Priority: 07.09.2023 IT 202300018378
(71) Applicant: STMicroelectronics International N.V., 1228 Plan-les-Ouates, Geneva (CH)
(72) Inventor: NOMELLINI, Andrea, 20159 MILANO (IT); GELMI, Ilaria, 20843 VERANO BRIANZA (MB) (IT); CAPRA, Federica, 29013 CARPANETO PIACENTINO (PC) (IT); VIMERCATI, Michele, 20833 GIUSSANO (MB) (IT); LAMAGNA, Luca, 20060 CASSINA DE' PECCHI (MI) (IT)
(74) Representative: Studio Torta S.p.A.

(57) **Abstract**

A process for manufacturing a microelectromechanical device (10) includes: on a body (13) containing semiconductor material, forming a sacrificial layer (18) of dielectric material having a first surface (18a), opposite to the body (13); conferring a sacrificial surface roughness to the first surface (18a) of the sacrificial layer (18); on the first surface (18a) of the sacrificial layer (18), forming a structural layer (112) of semiconductor material having a second surface (112a) in contact with the first surface (18a) of the sacrificial layer (18). Conferring sacrificial surface roughness to the first surface (18a) of the sacrificial layer (18) includes: on the sacrificial layer (18), forming a transfer layer (19) of semiconductor material with intrinsic porosity; and partially removing the sacrificial layer (18) through the transfer layer (19).

## Description

### Technical field

The present invention relates to a process for manufacturing microelectromechanical (MEMS) devices with reduced stiction phenomenon.

### Background

Inertial microelectromechanical (MEMS) devices, in particular, for example, gyroscopes and accelerometers, base their operation on masses coupled to a support body, such as for example a frame or a substrate of semiconductor material, with respect to which the masses are free to oscillate along one or more directions, in order to sense variations of a physical quantity or to function as actuators. These masses are commonly referred to as "movable", or "suspended" masses, and are also formed by a semiconductor material, typically for example by polycrystalline or monocrystalline silicon.

During the operation of a MEMS device or in response to a shock, the one or more movable masses may oscillate to the point of mechanically interfering with each other or with static elements of the device (for example stoppers or the same support body). Contact between surfaces of semiconductor materials, even more so if formed by the same semiconductor material such as for example silicon, may cause adhesion phenomena (known as "stiction"). Stiction may be irreversible, for example causing sticking of the movable masses to the static elements, and may compromise the functionality of the whole device.

Stiction may be caused by oscillations of the movable masses of both "in-plane" type and "out-of-plane" type. Typically, stiction due to out-of-plane oscillations is the most critical due to the dimensions of the surfaces involved.

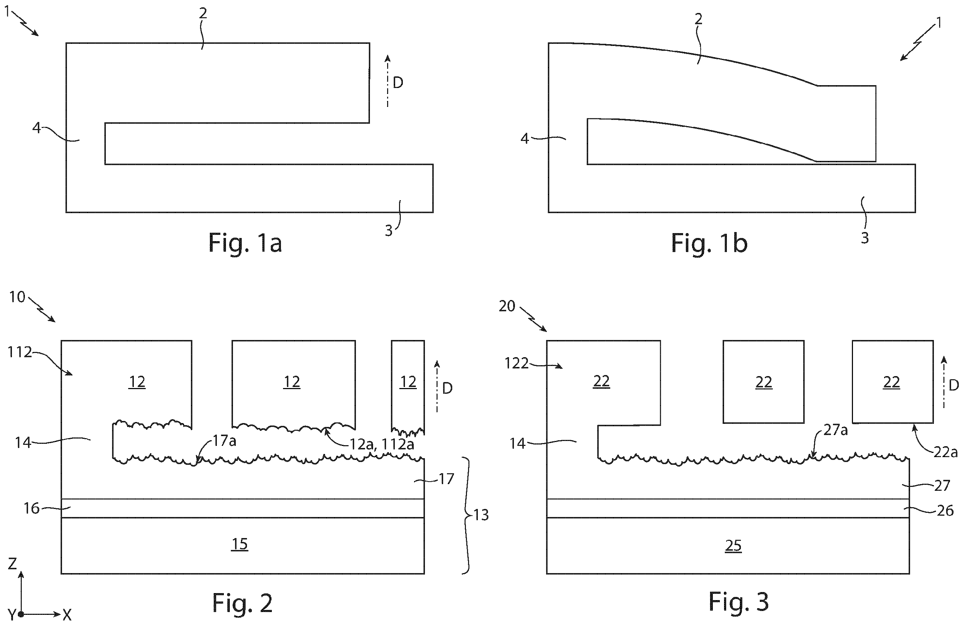

Figure 1a shows a portion of a generic MEMS device 1, for example an inertial sensor, comprising a movable mass 2 suspended with respect to a multilayer 3 by an anchor 4. The movable mass 2 may oscillate with respect to the multilayer 3 along a motion direction D (here, for example, with out-of-plane oscillations). The multilayer 3 comprises at least one polycrystalline silicon layer wherein, for example, fixed electrodes and/or buried electrical connections are formed. The MEMS device 1 may be subject to stiction phenomena between the movable mass 2 and the multilayer 3, in particular between respective facing silicon surfaces, especially if these surfaces have, on average, a flat profile. As shown in Figure 1b, the movable mass 2 may adhere to the underlying surfaces in an irreversible manner.

The most widespread solutions to limit the stiction issue may comprise reductions in the contact area between the movable mass 2 and the multilayer 3 and/or treatments of the facing surfaces of the movable mass 2 and the multilayer 3, such as for example anti-stiction coating applications. Such solutions, however, may impose severe limitations on the design of the elements of the MEMS devices, for example on the dimensions and materials of the movable masses, with possible resulting reductions in performances, or they may require complex additional steps in the manufacturing processes that complicate the implementation thereof.

### Summary

It is therefore an aim of the present invention to overcome or at least partially mitigate the disadvantages and limitations of the state of the art.

According to the present invention, a process for manufacturing microelectromechanical devices as defined in the attached claims is provided.

### Brief Description of the Figures

For a better understanding of the present invention, preferred embodiments are provided, by way of non-limiting example, with reference to the attached drawings, wherein:
- Figures 1a-1b schematically show in a cross-section a portion of a MEMS device in two respective conditions, according to the state of the art;
- Figure 2 schematically shows in a cross-section a portion of a MEMS device in accordance with an embodiment of the present invention;
- Figure 3 schematically shows in a cross-section a portion of a MEMS device in accordance with a different embodiment of the present invention;
- Figures 4a-4g schematically show in a cross-section the MEMS device of Figure 2 in successive processing steps of a manufacturing process in accordance with an embodiment of the present invention; and
- Figures 5a-5g schematically show in a cross-section the MEMS device of Figure 3 in successive processing steps of a manufacturing process in accordance with a different embodiment of the present invention.

### Description of Embodiments

Figure 2 illustrates a portion of a microelectromechanical, or MEMS, device 10 in accordance with one embodiment of the present invention, for example, an inertial sensor, such as an accelerometer or a gyroscope. The MEMS device 10 comprises a movable mass 12 and a multilayer 13 with respect to which the movable mass 12 is coupled so as to be capable of oscillating along a motion direction D. In detail, the movable mass 12 is suspended with respect to the multilayer 13 by a fixed anchor 14 and the oscillations of the movable mass 12 along the motion direction D are of the "out-of-plane" type: considering a reference system of axes orthogonal to each other X, Y, Z, the movable mass 12 and the multilayer 13, in fact, mainly extend in planes parallel to the XY-plane and the motion direction D, for example a sensing or driving direction, is parallel to the Z-axis. The MEMS device 10 is capable, therefore, of sensing or actuating displacements along the Z-axis and is shown in Figure 2 in a rest condition, i.e. when the movable mass 12 is stationary. By way of non-limiting example, the movable mass 12 may be a membrane, a cantilever structure or a structure oscillating around a fulcrum axis perpendicular to the Z-axis ("teeter-totter"). In the latter case, the movable mass 12 may be connected to the anchor through flexures not shown for simplicity.

The movable mass 12 of the MEMS device 10 is of polycrystalline silicon and may comprise a plurality of elements not shown, for example electrodes, movable with respect to the multilayer 13. The multilayer 13 is a structure of different layers stacked and in contact with each other and comprises a substrate 15 of semiconductor material, for example of monocrystalline silicon, a permanent dielectric layer 16, for example of silicon oxide, arranged on the substrate 15 and a connection layer 17, for example of polycrystalline silicon, arranged on the permanent dielectric layer 16. The connection layer 17 is suitably doped so as to be electrically conductive and is patterned in order to form fixed electrodes (not shown in detail), for example capacitively coupled with the plurality of movable electrodes of the movable mass 12. Alternatively, the fixed electrodes may be coupled, again in a capacitive manner, directly to the movable mass 12. The anchor 14, also for example of polycrystalline silicon, is fixed to the multilayer 13, and more in particular to the connection layer 17.

The movable mass 12 and the connection layer 17 are each provided with a respective main face 12a, 17a mutually facing, which are as a first approximation parallel to each other and extend perpendicularly to the Z-axis. The main face 12a of the movable mass 12 and the main face 17a of the connection layer 17 are separated from each other by a distance, along the Z-axis, at least equal to the dimension of the anchor 14.

As shown in Figure 2, the main face 17a of the connection layer 17 has a roughness, intentionally created, hereinafter referred to as connection surface roughness. The main face 12a of the movable mass 12 also has, according to one aspect of the present invention and as described in greater detail below, a roughness, intentionally created, which is referred to as structural surface roughness. The connection surface roughness and the structural surface roughness may be different from each other. The connection surface roughness and the structural surface roughness have the effect of reducing the stiction phenomenon between the movable mass 12 and the multilayer 13, and in general of increasing the resistance to stiction of the MEMS device 10.

Figure 3 illustrates a portion of a MEMS device 20 in accordance with a different embodiment. Elements already present in the MEMS device 10 are indicated with the same reference marks; furthermore, as will be clearer hereinbelow, the MEMS device 20 is manufactured using different steps with respect to those used to manufacture the MEMS device 10.

The MEMS device 20 comprises a support substrate 25 of semiconductor material, and in particular of monocrystalline silicon, a dielectric bonding layer 26, for example of silicon oxide, arranged on the support substrate 25, and a connection layer 27, for example of polycrystalline silicon, arranged on the dielectric bonding layer 26. The MEMS device 20 also comprises a movable mass 22, coupled to the connection layer 27 by the anchor 14 and suspended with respect to the connection layer 27 so as to be capable of oscillating along the motion direction D.

The movable mass 22 extends mainly in a plane parallel to the xy-plane, is formed by monocrystalline silicon and comprises a plurality of elements not shown, for example electrodes, movable with respect to the connection layer 27. The connection layer 27 is suitably doped so as to be electrically conductive and is patterned in order to form fixed electrodes (not shown in detail), for example capacitively coupled with the plurality of movable electrodes of the movable mass 22. Alternatively, the fixed electrodes may be coupled, again in a capacitive manner, directly to the movable mass 22. The MEMS device 20 is shown in Figure 3 in a rest condition, i.e. when the movable mass 22 is stationary.

The movable mass 22 and the connection layer 27 are each provided with a respective main face 22a, 27a mutually facing, which are as a first approximation parallel to each other and extend perpendicularly to the Z-axis. The main face 22a of the movable mass 22 and the main face 27a of the connection layer 27 are separated from each other by a distance, along the Z-axis, at least equal to the dimension of the anchor 14.

In the MEMS device 20, as visible in Figure 3, the main face 27a of the connection layer 27 has a roughness intentionally created and corresponding to the aforementioned structural surface roughness. The structural surface roughness has the function of reducing the stiction phenomenon between the movable mass 22 and the connection layer 27, and in general of increasing the resistance to stiction of the MEMS device 20.

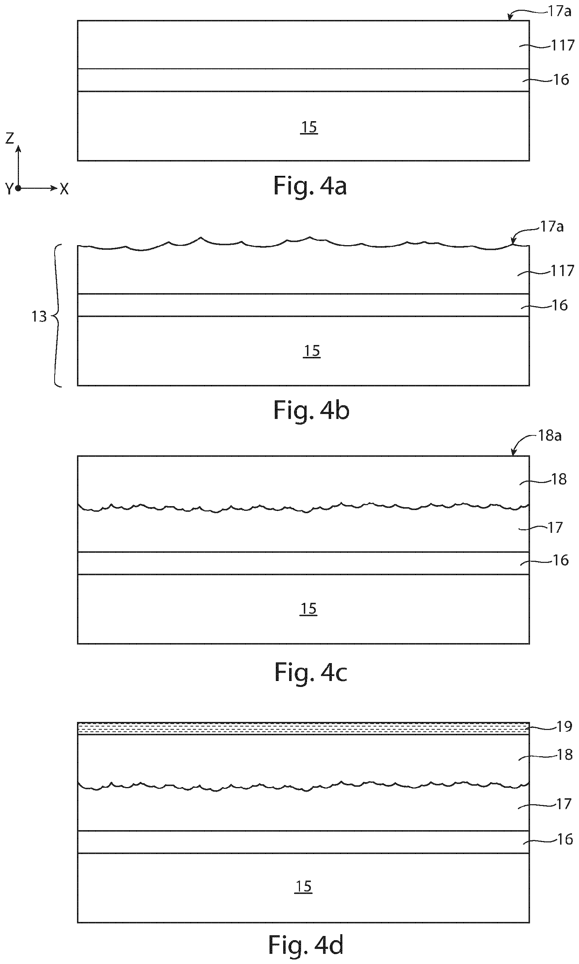

The MEMS device 10 of Figure 2 is obtained by an embodiment of the manufacturing process subject matter of the present invention, whose consecutive steps are shown in Figures 4a-4g.

Figure 4a shows, in a cross-section, a semiconductor wafer which comprises the substrate 15. The permanent dielectric layer 16 is formed above and in contact with the substrate 15, for example by Chemical Vapour Deposition (CVD) of silicon oxide or by thermal oxidation. A first polycrystalline silicon layer 117 is then formed above and in contact with the permanent dielectric layer 16, for example by deposition and more in particular by CVD. The first polycrystalline silicon layer 117 has an exposed surface which substantially corresponds to the main face 17a of the connection layer 17. The first polycrystalline silicon layer 117 is doped, for example with phosphorus or boron, and has a thickness, along the Z-axis, for example comprised between 100nm and 5um.

The formation of the first polycrystalline silicon layer 117 may be controlled so that the respective main face 17a has a predetermined roughness (Figure 4b), corresponding to the connection surface roughness. For example, roughness root mean square (RMS) values comprised between 5 and 50 nm (with a typical value, for example, equal to 20nm) and peak-to-peak values, measured along the Z-axis, comprised between 120 and 230 nm (with a typical value, for example, equal to 210nm) may be obtained for the connection surface roughness.

The connection layer 17 of Figure 2 is thus formed from the first polycrystalline silicon layer 117: although not shown in the attached Figures, it is understood that the present manufacturing process comprises steps of patterning conductive regions within the first polycrystalline silicon layer 117, such as for example fixed electrodes and connections buried in the permanent dielectric layer 16.

A sacrificial layer 18 is formed above the connection layer 17 (Figure 4c), for example by deposition, with a thickness at least equal to the dimension, along the Z-axis, of the anchor 14 of the MEMS device 10. The sacrificial layer 18 is formed by a dielectric, for example by silicon oxide. The sacrificial layer 18 thus formed has an exposed surface hereinafter referred to as transferring surface 18a.

With reference to Figure 4d, a transfer layer 19 is formed above the sacrificial layer 18 and in particular in contact with the transferring surface 18a, for example by deposition, with a thickness for example comprised between 50 and 250 nm (with a typical value, for example, equal to 100nm); the transfer layer 19 may therefore be considered "thin" with respect to the sacrificial layer 18. The transfer layer 19 is formed by a semiconductor material with intrinsic porosity. The transfer layer 19 is for example of polycrystalline silicon with intrinsic porosity having a full/empty mass ratio lower than 800.

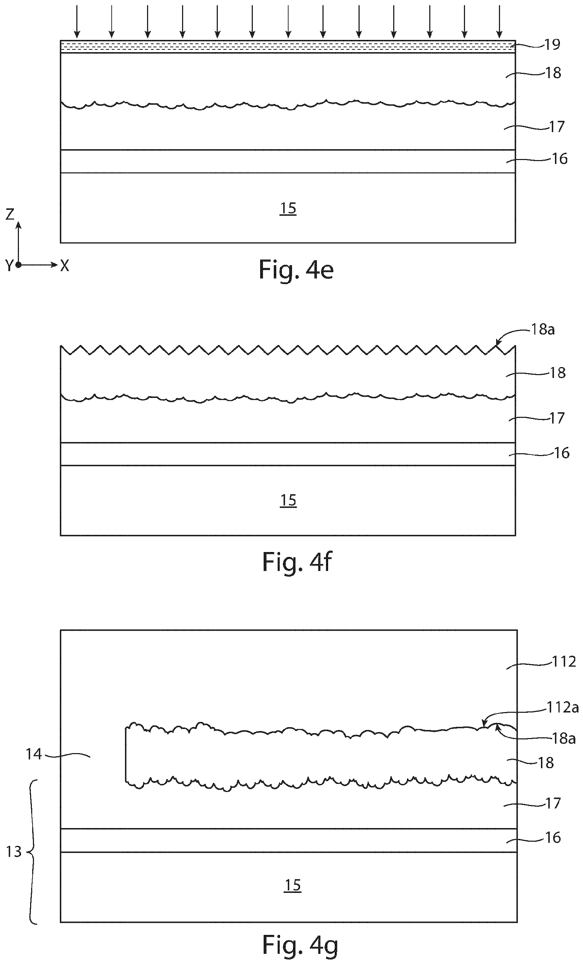

The Applicant has verified that by performing a dry etching through the transfer layer 19 (Figure 4e) the sacrificial layer 18 may be partially removed while conferring to the transferring surface 18a of the residual sacrificial layer 18 a predetermined roughness (Figure 4f), which is referred to as sacrificial surface roughness. This roughness of the transferring surface 18a is determined by the fact that the removal of the sacrificial layer 18 is irregular due to the intrinsic porosity of the transfer layer 19. The dry removal may be for example a plasma ion bombardment, of anisotropic type, of the transfer layer 19, performed using fluorine and/or bromine and/or chlorine ions and pressures in the etching chamber comprised between 6mTorr and 70mTorr.

The sacrificial layer 18 is then patterned by known lithographic techniques so as to obtain respective openings (not shown) in which the support structures of the movable mass 12 of the MEMS device 10, such as for example the anchor 14, are formed later.

With reference to Figure 4g, a second polycrystalline silicon layer 112 is formed above the sacrificial layer 18 and in particular in contact with the transferring surface 18a, for example by deposition and with a thickness, along the Z-axis, for example comprised between 1pm and 100pm. Reference is made to the surface of the second polycrystalline silicon layer 112 in contact with the transferring surface 18a with transferred surface 112a. In this step, the openings in the sacrificial layer 18 are filled and the support structures for the movable mass 12 of the MEMS device 10, in particular the anchor 14, are formed.

According to one aspect of the present invention, since the second polycrystalline silicon layer 112 is formed in contact with the sacrificial layer 18, the transferred surface 112a of the second polycrystalline silicon layer 112 acquires roughness properties as a first approximation complementary to the roughness of the transferring surface 18a of the sacrificial layer 18. In practice, the second polycrystalline silicon layer 112 and, more in detail, the respective transferred surface 112a, are obtained by using the sacrificial layer 18 as a mold. The roughness of the transferred surface 112a corresponds to the structural surface roughness of the MEMS device 10 and is complementary to the sacrificial surface roughness of the transferring surface 18a, replicating, "in a complementary manner", the profile thereof. The profile of the transferred surface 112a is in fact obtained by transferring the profile of the sacrificial layer 18.

For example, roughness root mean square (RMS) values comprised between 5 and 20 nm (with a typical value, for example, equal to 8nm) and peak-to-peak values, measured along the Z-axis, comprised between 10 and 100 nm (with a typical value, for example, equal to 40nm) may be obtained for the structural surface roughness.

Finally, the second polycrystalline silicon layer 112 is patterned to form the movable mass 12 of the MEMS device 10 and the structures related thereto (such as for example, flexures). In detail, the second polycrystalline silicon layer 112 is opened up to the sacrificial layer 18, for example by dry removal, to pattern the flexures and any other elements not shown, in accordance with the design preferences. Wherever remaining, the transferred surface 112a therefore forms the main face 12a of the movable mass 12. The sacrificial layer 18 is then selectively removed, for example in a hydrofluoric acid environment, and the movable mass 12 released, thereby achieving the MEMS device 10 of Figure 2.

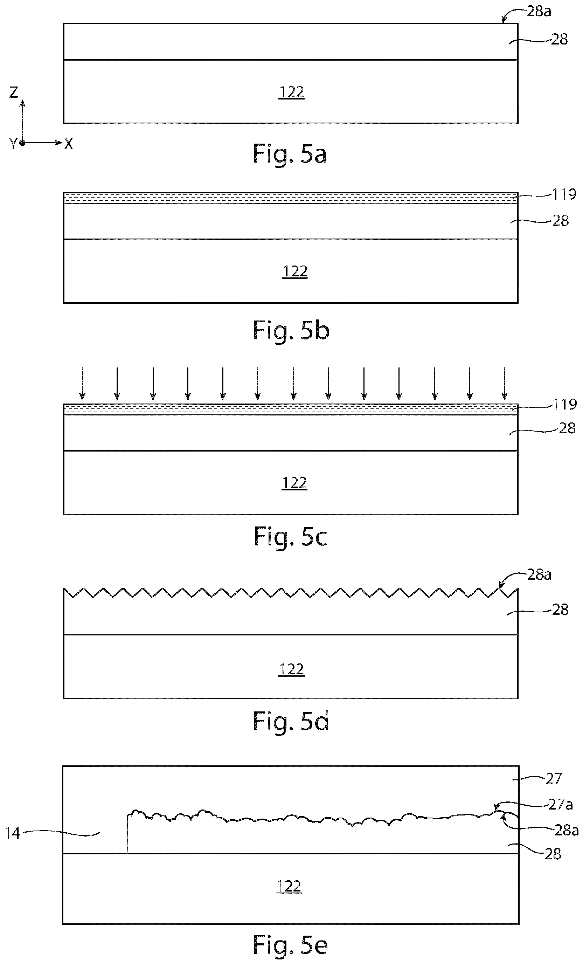

The MEMS device 20 of Figure 3 is obtained by a different embodiment of the manufacturing process subject matter of the present invention, whose consecutive steps are shown in Figures 5a-5g. Elements already present in the manufacturing process of the MEMS device 10 are indicated with the same reference marks.

Figure 5a shows, in a cross-section, a work wafer 122 of monocrystalline silicon. A sacrificial layer 28 is formed above and in contact with the work wafer 122, for example by deposition, with a thickness at least equal to the dimension, along the Z-axis, of the anchor 14 of the MEMS device 20. The sacrificial layer 28 is formed by a dielectric, for example, by silicon oxide. The sacrificial layer 28 thus formed is provided with an exposed surface hereinafter referred to as transferring surface 28a.

A transfer layer 119, substantially as already described with reference to Figures 4d and 4e, is formed above the sacrificial layer 28 and in particular in contact with the transferring surface 28a (Figure 5b).

By performing a dry removal of the sacrificial layer 28 through the transfer layer 119, as previously described (Figure 5c), the intermediate surface roughness is conferred to the transferring surface 28a (Figure 5d).

The sacrificial layer 28 is then patterned by known lithographic techniques so as to obtain respective openings (not shown) wherein then the support structures of the movable mass 22 of the MEMS device 20, such as for example the anchor 14, are formed.

With reference to Figure 5e, a polycrystalline silicon layer corresponding to the connection layer 27 of the MEMS device 20 is formed above the sacrificial layer 28 and in particular in contact with the transferring surface 28a, for example by deposition or epitaxial growth and with a thickness, along the Z-axis, for example comprised between 100nm and 5um. The connection layer 27 is doped, for example, with phosphorus or boron, in order to confer the desired conductive properties thereof. The surface of the connection layer 27 in contact with the transferring surface 28a of the sacrificial layer 28 corresponds to the main face 27a of Figure 3 and is interchangeably referred to as transferred surface 27a.

According to one aspect of the present invention, since the connection layer 27 is formed in contact with the sacrificial layer 28, the transferred surface 27a of the connection layer 27 acquires roughness properties as a first approximation complementary to the roughness of the transferring surface 28a of the sacrificial layer 28. In practice, the connection layer 27 and, more in detail, the respective transferred surface 27a, are obtained by using the sacrificial layer 28 as a mold. The roughness of the transferred surface 27a corresponds to the structural surface roughness of the MEMS device 20 and is complementary to the sacrificial surface roughness of the transferring surface 28a, replicating, "in a complementary manner", the profile thereof. The profile of the transferred surface 27a is in fact obtained by transferring the profile of the sacrificial layer 28.

Finally, formation and patterning steps follow so as to form the movable mass 22 of the MEMS device 20 and the structures related thereto (such as for example, flexures). In detail, the movable mass 22 of the MEMS device 20 is obtained by a semiconductor wafer bonding technique (known as wafer-to-wafer bonding technique).

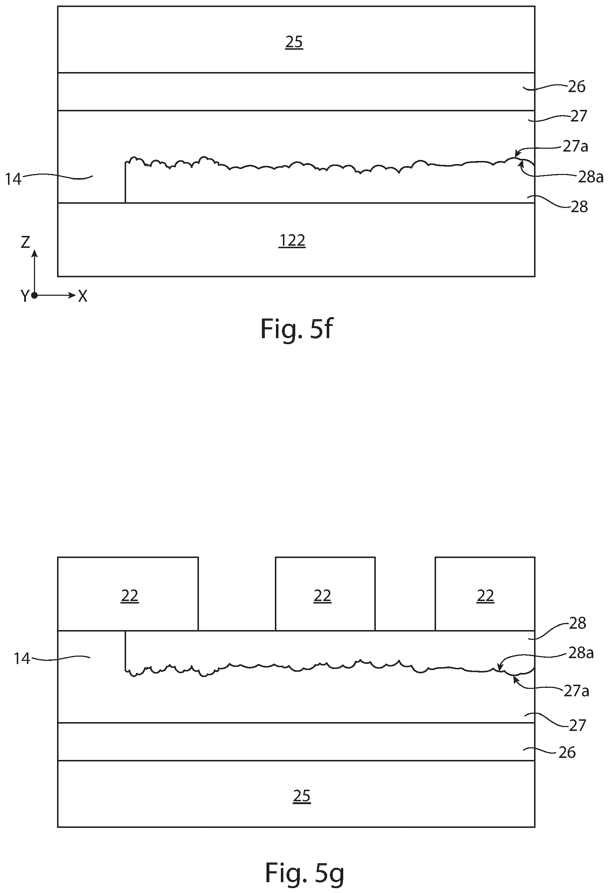

With reference to Figure 5f, a silicon oxide layer is formed above and in contact with the connection layer 27, for example by CVD deposition, forming the dielectric bonding layer 26. A handle monocrystalline silicon wafer is bonded by the dielectric bonding layer 26 to the connection layer 27, for example by a thermal bonding process. The handle monocrystalline silicon wafer comprises a substrate intended to form the support substrate 25 of the MEMS device 20.

The wafer of Figure 5f is then flipped over with respect to the Z-axis (Figure 5g) obtaining the orientation of Figure 3, wherein the support substrate 25 lies below the connection layer 27. The work wafer 122 of monocrystalline silicon is then opened up to the sacrificial layer 28 patterning the movable mass 22 and, for example by dry removal, to pattern the flexures and any other elements not shown, in accordance with the design preferences. The sacrificial layer 28 is finally selectively removed, for example by removal in a hydrofluoric acid environment, and the movable mass 22 released, thereby achieving the MEMS device 20 of Figure 3.

The manufacturing process according to the two embodiments described above allows the alternative use of monocrystalline silicon and polycrystalline silicon for the movable masses of the MEMS device. The roughnesses intentionally created on the surfaces of the movable masses and on the surfaces of the structures underlying the movable masses, and in particular on the surfaces of the conductive layers - in polycrystalline silicon - arranged facing the movable masses, according to the steps described above, allow a reduction of the stiction phenomenon of the movable masses to the underlying structures. In particular, the steps of forming these surface roughnesses are easy to implement; furthermore, transferring roughness properties between different and consecutively formed layers makes the process controllable and flexible in terms of obtainable profiles. More in detail, through the present manufacturing process, the choice of the semiconductor material for the movable masses may be independent of the choice of the semiconductor material used for the underlying structures (such as the conductive layers), for example they may be different from each other. Furthermore, the formation of surface roughnesses is independent of the steps of forming the respective structures and in particular of the process flow followed.

Finally, it is clear that modifications and variations may be made to what is described and illustrated herein without thereby departing from the scope of the present invention, as defined in the attached claims.

For example, the movable mass may be a structure having cantilever elements (known as a "cantilever") and the MEMS device be an electro-acoustic transducer. Alternatively, the movable mass may be a membrane capable of vibrating, for example, within a pressure sensor. Or again, the MEMS device may be an accelerometer designed for out-of-plane measurements and the movable mass have, in section, the shape of a beam capable of oscillating around a non-barycentric axis.

In a variation not shown, the connection surface roughness and/or the structural surface roughness are formed in a manner that is inhomogeneous and/or localized on the respective surfaces. For example, surface roughnesses may be locally selectable using specific masks.

## Claims

1. A process for manufacturing a microelectromechanical device (10; 20) comprising:
- on a body (13; 122) containing semiconductor material, forming a sacrificial layer (18; 28) of dielectric material having a first surface (18a; 28a), opposite to the body (13; 122) ;
- conferring a sacrificial surface roughness to the first surface (18a; 28a) of the sacrificial layer (18; 28), wherein conferring comprises forming a transfer layer (19; 119) of semiconductor material with intrinsic porosity on the sacrificial layer (18; 28) and partially removing the sacrificial layer (18; 28) through the transfer layer (19; 119); and
- on the first surface (18a; 28a) of the sacrificial layer (18; 28), forming a structural layer (112; 27) of semiconductor material having a second surface (112a; 27a) in contact with the first surface (18a; 28a) of the sacrificial layer (18; 28).

2. The manufacturing process according to claim 1, wherein the sacrificial surface roughness is defined by root mean square values comprised between 5 and 20 nm.

3. The manufacturing process according to any of the preceding claims, wherein the transfer layer (19; 119) is of polycrystalline silicon with an intrinsic porosity having a full/empty mass ratio lower than 800.

4. The manufacturing process according to any of the preceding claims, wherein the sacrificial layer (18; 28) is of silicon oxide.

5. The manufacturing process according to any of the preceding claims, wherein partially removing the sacrificial layer (18; 28) comprises dry etching the sacrificial layer (18; 28).

6. The manufacturing process according to any of the preceding claims, wherein the body (13) comprises: a substrate (15) of semiconductor material; a permanent dielectric layer (16) arranged on the substrate (15); and an electrically conductive connection layer (17) arranged on the permanent dielectric layer (16).

7. The manufacturing process according to the preceding claim, further comprising:
anchoring the structural layer (112) to the connection layer (17);
forming a movable mass (12) from the structural layer (112); and
selectively removing the sacrificial layer (18), thus releasing the movable mass (12);
wherein the movable mass (12) is constrained to the connection layer (17) so as to be capable of oscillating along at least one motion direction (D) transverse to the connection layer (17).

8. The manufacturing process according to the preceding claim, further comprising conferring a connection surface roughness to a main face (17a) of the connection layer (17), the main face (17a) facing the movable mass (12);
wherein the connection layer (17) is of polycrystalline silicon.

9. The manufacturing process according to any of claims 1 to 5, further comprising:
anchoring the structural layer (27) to the body (122);
forming a dielectric bonding layer (26) on the structural layer (27);
bonding a support substrate (25) of semiconductor material to the dielectric bonding layer (26);
forming a movable mass (22) from the body (122); and
selectively removing the sacrificial layer (28), thus releasing the movable mass (22);
wherein the movable mass (22) is constrained to the structural layer (27) so as to be capable of oscillating along at least one motion direction (D) transverse to the structural layer (27).

10. The manufacturing process according to the preceding claim, wherein the body (122) is of monocrystalline silicon;
and wherein the structural layer (27) is electrically conductive.

11. The manufacturing process according to any of the preceding claims, wherein the second surface (112a; 27a) of the structural layer (112; 27) has a structural surface roughness, the structural surface roughness being complementary to the sacrificial surface roughness.

12. The manufacturing process according to any of the preceding claims, wherein the structural layer (112; 27) is of polycrystalline silicon.

13. A microelectromechanical device (10; 20) comprising:
- a body (13; 122) containing semiconductor material and having a main face (17a; 22a); and
- a structural layer (112; 27) of semiconductor material, having a surface (112a; 27a) facing the main face (17a; 22a) of the body (13; 122),
wherein at least one of the main face (17a; 22a) and the surface (112a; 27a) has a surface roughness.

14. The device (10) according to claim 13, wherein the body (13) comprises: a substrate (15) of semiconductor material; a permanent dielectric layer (16) arranged on the substrate (15); and an electrically conductive connection layer (17) arranged on the permanent dielectric layer (16), the connection layer (17) being delimited by the main face (17a) ;
the device (10) further comprising a movable mass (12) formed from the structural layer (112), the movable mass (12) being delimited by the surface (112a),
wherein the movable mass (12) is constrained to the connection layer (17) so as to be capable of oscillating along at least one motion direction (D) transverse to the connection layer (17);
and wherein the main face (17a) has a connection surface roughness and the surface (112a) has a structural surface roughness.

15. The device (20) according to claim 13, further comprising:
- a dielectric bonding layer (26) arranged on the structural layer (27) and opposite to the surface (27a);
- a support substrate (25) of semiconductor material bonded to the dielectric bonding layer (26); and
- a movable mass (22) formed from the body (122), the movable mass (22) being delimited by the main face (22a),
wherein the movable mass (22) is constrained to the structural layer (27) so as to be capable of oscillating along at least one motion direction (D) transverse to the structural layer (27);
and wherein the structural layer (27) is electrically conductive and the surface (27a) has a structural surface roughness.
